# EUROPÄISCHE PATENTSCHRIFT

(11) **EP 1 464 113 B1**
(45) Veröffentlichungstag und Bekanntmachung des Hinweises auf die Patenterteilung: **31.05.2006**
(21) Anmeldenummer: 02795182.1
(22) Anmeldetag: 12.12.2002
(51) Int. Cl.: H03H 3/02

(54) **VERFAHREN ZUR HERSTELLUNG EINER TOPOLOGIEOPTIMIERTEN ELEKTRODE FÜR EINEN RESONATOR IN DÜNNFILMTECHNOLOGIE**
METHOD FOR PRODUCING A TOPOLOGY-OPTIMIZED ELECTRODE FOR A THIN FILM RESONATOR
PROCEDE POUR LA PRODUCTION D'UNE ELECTRODE A TOPOLOGIE OPTIMISEE POUR UN RESONATEUR EN TECHNOLOGIE A COUCHE MINCE

(30) Priorität: 11.01.2002 DE 10200741
(43) Veröffentlichungstag der Anmeldung: 06.10.2004
(73) Patentinhaber: Infineon Technologies AG, 81669 München (DE)
(72) Erfinder: AIGNER, Robert, 82008 Unterhaching (DE); ELBRECHT, Lueder, 81825 München (DE); MARKSTEINER, Stephan, 85640 Putzbrunn (DE); NESSLER, Winfried, 81739 München (DE)
(74) Vertreter: Schoppe, Fritz
(86) Internationale Anmeldenummer: PCT/EP2002/014190
(87) Internationale Veröffentlichungsnummer: WO 2003/058811

(56) Entgegenhaltungen:
- WO-A-01/24361
- US-A- 5 618 381
- US-A- 5 647 932
- US-A- 5 771 555
- US-A1- 2001 021 594

## Beschreibung

Die vorliegende Erfindung bezieht sich auf ein Verfahren zur Herstellung einer Elektrode für einen Resonator in Dünnfilmtechnologie, insbesondere auf ein Verfahren zur Herstellung eines Resonators, der eine piezoelektrische Schicht umfasst, die teilweise zwischen einer unteren Elektrode und einer oberen Elektrode angeordnet ist, und hier insbesondere auf die Herstellung eines BAW-Resonators (BAW = Bulk Acoustic Wave = akustische Volumenwelle).

Z.B. das Patent US-A-5771555 offenbart ein Herstellungsverfahren eines BAW-Resonators.

Bei der Herstellung von Frequenzfiltern in Dünnfilmtechnologie unter Verwendung von Dünnschicht-Volumenresonatoren (FBAR = Film Bulk Acoustic Resonator), welche auch als BAW-Resonatoren bezeichnet werden, wird die Abscheidung der piezoelektrischen Schicht, beispielsweise einer AlN-Schicht, einer ZnO-Schicht oder PZT-Schicht in der Regel über einen reaktiven Sputterprozess bewerkstelligt. Der reaktive Sputterprozess wird bevorzugt, da dieser eine relativ niedrige Prozesstemperatur erfordert, sowie gut kontrollierbare und reproduzierbare Abscheidebedingungen bietet. Ferner wird durch den reaktiven Sputterprozess eine Dünnschicht mit guter Qualität erzeugt.

Ein Problem bei der Erzeugung der Dünnschichten tritt aufgrund der spezifischen Wachstumsbedingungen von piezoelektrischen Schichten auf, bei denen Kristallite einer bestimmten Vorzugsorientierung schneller wachsen als diejenigen mit anderen Orientierungen. Diese speziellen Wachstumsbedingungen der piezoelektrischen Schichten führen in Kombination mit der schlechten Kantenbedeckung eines Sputterprozesses zur Ausbildung von Wachstumsdefekten an den Topologiestufen.

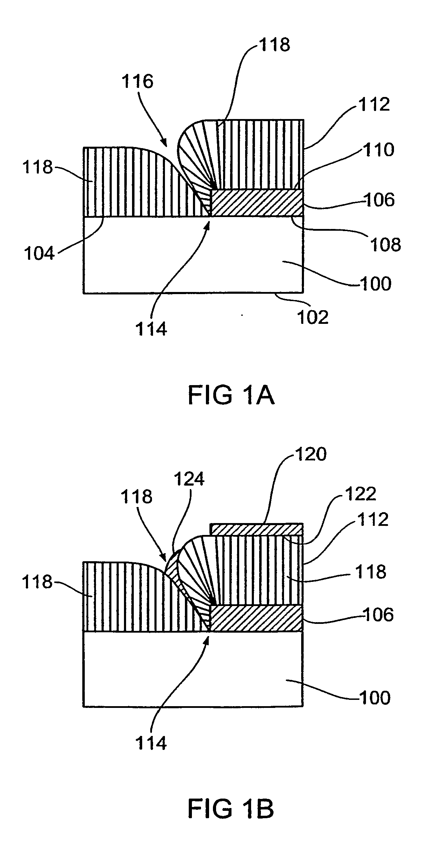

Diese Wachstumsdefekte werden nachfolgend anhand der Fig. 1 näher erläutert. In Fig. 1A ist eine Anordnung gezeigt, welche ein Substrat 100 umfasst, das eine erste, untere Oberfläche 102 sowie eine zweite, obere Oberfläche 104 aufweist. Auf der oberen Oberfläche 104 ist in einem Abschnitt eine erste, untere Elektrode 106 gebildet, die wiederum eine erste, untere Oberfläche 108 sowie eine zweite, obere Oberfläche 110 umfasst. Auf dem nicht durch die Elektrode 106 bedeckten Abschnitt der oberen Oberfläche 104 des Substrats 100 sowie auf der oberen Oberfläche 110 der Elektrode 106 wurde mittels des oben erwähnten Sputterprozesses eine piezoelektrische Schicht 112, bei dem dargestellten Beispiel eine AlN-Schicht, erzeugt.

Wie in Fig. 1A zu erkennen ist, ist aufgrund der Anordnung der Elektrode 106 auf der Oberfläche 104 des Substrats 100 eine Stufe 114 (Topologiestufe) gebildet, an der es aufgrund der schlechten Kantenbedeckung eines Sputterprozesses und aufgrund der spezifischen Wachstumsbedingungen der piezoelektrischen Schicht 112 während des Sputterprozesses zu einem Wachstumsdefekt kommt, der in Fig. 1A allgemein mit dem Bezugszeichen 116 angedeutet ist. In Fig. 1A ist mit dem Bezugszeichen 118 eine Vorzugsrichtung des Aufwachsens der piezoelektrischen Schicht in den verschiedenen Bereichen dargestellt. Im Bereich der Stufe 114 ist eine Versetzung dieser Linien 118 zu erkennen, was zu der Erzeugung des Wachstumsdefekts 116 geführt hat. Die Versetzungslinien und die hieraus resultierenden Defekte sind aus den nachfolgend dargelegten Gründen unerwünscht und führen zu Problemen hinsichtlich der Zuverlässigkeit des zu erzeugenden Bauelements, insbesondere in Zusammenhang mit der nachfolgenden Abscheidung einer oberen Elektrode.

Genauer gesagt wird bei einer anschließenden Abscheidung und Strukturierung einer Metallisierung zur Erzeugung der oberen Elektrode ein metallischer Spacer zurückbleiben, der nachfolgend zu elektrischen Kurzschlüssen führen kann, wodurch die Funktionalität des Bauelements, z.B. eines Filters, verschlechtert oder ganz zerstört werden kann. In Fig. 1B ist die Struktur dargestellt, welche sich ausgehend von der Fig. 1A ergibt, nachdem eine ganzflächig abgeschiedene Metallisierung, zur Erzeugung einer oberen Elektrode strukturiert wurde. In Fig. 1B ist eine zweite, obere Elektrode 120 gezeigt, die auf einer dem Substrat 100 abgewandten Oberfläche 122 der piezoelektrischen Schicht 112 derart gebildet ist, dass dieselbe der Elektrode 106 zumindest teilweise gegenüberliegt. In dem Bereich, in dem die Elektrode 106 und die obere Elektrode 120 sich überlappen, ist der Dünnschicht-Volumenresonator gebildet. Wie in Fig. 1B ferner zu erkennen ist, ist im Bereich des Wachstumsdefekt 116 ein Metallrest 124 (metallischer Spacer) zurückgeblieben. Dieser metallische Spacer 124 führt zu den gerade erwähnten Problemen im Zusammenhang mit elektrischen Kurzschlüssen und ähnlichem.

Ein weiterer Nachteil der in Fig. 1 beschriebenen Struktur besteht darin, dass normalerweise zur Unterdrückung von unerwünschten Störmoden (Spurious Modes) ein Konzept angewendet wird, bei dem ein Bereich außerhalb der oberen Elektrode 120 über mehrere Mikrometer Breite eine definierte Geometrie, d. h. eine definierte Dicke, hat. Wie in Fig. 1A und 1B zu sehen ist, kann dies nur dann erreicht werden, wenn die obere Elektrode 120 deutlich kleiner ausgestaltet wird als die Elektrode 106, so dass hierdurch eine Vergrößerung der Struktur zur Unterdrückung der unerwünschten Störmoden erforderlich ist, was die Gesamtgröße der Struktur erhöht. Ferner wird hierdurch das Verhalten des sich ergebenden Resonatorbauelements hinsichtlich Bandbreite und parasitärer Kapazitäten deutlich verschlechtert.

Ein weiteres Problem bei dem anhand der Fig. 1 beschriebenen Herstellungsverfahren besteht darin, dass in den Bereichen, in denen die obere Elektrode 120 die Wachstumsdefekte überquert, was immer erforderlich ist, eine Schwachstelle der piezoelektrischen Schicht gegeben ist, und zwar bezüglich eines dielektrischen Durchbruchs. Aufgrund des Wachstumsdefekts 116 (Fehlstelle) lässt sich daher nicht die erwünschte ESD-Festigkeit (ESD = Electro Static Discharge = elektostatische Entladung) erreichen, die bei einer vollständig planaren Anordnung erwartet würde.

Grundsätzlich wurde das anhand der Fig. 1A beschriebene Verfahren und insbesondere die damit zusammenhängenden Probleme im Stand der Technik bisher gar nicht diskutiert. Prinzipiell lässt sich der metallische Spacer 124 durch eine starke Überätzung bei der Strukturierung der oberen Elektrode 120 verringern. Aufgrund des starken Überhangs der piezoelektrischen Schicht 112 kann er trotz des Ätzens nicht vollständig entfernt werden. Dies kann erst durch eine weitere isotrope Ätzung der oberen Elektrode, z. B. durch eine Nassätzung, erreicht werden. Der Nachteil dieser Vorgehensweise besteht jedoch darin, dass bedingt durch eine schlecht kontrollierbare Unterätzung der Lackmaske die resultierende Elektrodenkante bezüglich anderer Schichten schlecht justiert ist, wodurch sich wiederum eine Verschlechterung des Störmodenverhaltens ergibt.

An dieser Stelle sei darauf hingewiesen, dass das Substrat 100 in der Regel wiederum aus einer Folge von mehreren Schichten bestehen kann. Diese Schichten können ihrerseits strukturiert sein und so selbst zur Entstehung von Topologiestufen beitragen. Ein typisches Beispiel hierfür ist ein sog. Akustischer Spiegel, d.h. eine Abfolge von Schichte mit hoher und niedriger akustischer Impedanz. Zur Vereinfachung der Darstellung in Fig. 1 wurde auf diese Details verzichtet und das Substrat 100 als homogener Block gezeichnet.

Ausgehend von diesem Stand der Technik liegt der vorliegenden Erfindung die Aufgabe zugrunde, ein verbessertes Verfahren zur Erzeugung einer topologieoptimierten Elektrode für einen Resonator in Dünnfilmtechnologie zu schaffen, welches das Auftreten von Wachstumsdefekten beim Erzeugen der piezoelektrischen Schicht und die damit verbundenen Probleme vermeidet.

Diese Aufgabe wird durch ein Verfahren nach Anspruch 1 gelöst.

Die vorliegende Erfindung schafft ein Verfahren zur Herstellung einer Elektrode (106) für einen Resonator in Dünnfilmtechnologie, wobei das Verfahren folgenden Schritt umfasst:

Einbetten der Elektrode des Resonators in einer isolierenden Schicht, derart, dass eine Oberfläche der Elektrode freiliegt, und dass eine durch die Elektrode und die isolierende Schicht festgelegte Oberfläche im wesentlichen planar ist.

Gemäß der vorliegenden Erfindung wird ein Herstellungsverfahren für die Elektrode für Resonatoren in Dünnfilmtechnologie, z. B. BAW-Resonatoren, geschaffen, bei denen die oben angesprochenen Nachteile im Stand der Technik dadurch vermieden werden, dass die unerwünschte Topologiestufe der Elektrode vermieden wird. Hierzu werden Bereiche außerhalb der Elektrode mit einer dielektrischen Schicht, z.B. Siliziumoxid oder Siliziumnitrid, bis zur Höhe der Oberkante der Elektrode aufgefüllt. Der Vorteil der vorliegenden Erfindung besteht darin, dass dies auf eine technologisch besonders einfache Art und Weise erreicht werden kann.

Gemäß einem ersten bevorzugten Ausführungsbeispiel wird hierzu zunächst die dielektrische Schicht auf einer gesamten Oberfläche eines Substrats/Wafers, auf dem bereits die Elektrode gebildet ist, abgeschieden, und zwar mit einer Dicke die in etwa der Topologiestufe entspricht. Anschließend wird durch chemisch mechanisches Polieren die isolierende Schicht derart abgetragen, dass eine obere Oberfläche der Elektrode freiliegt, wobei die Abtragung derart erfolgt, dass die Dicken der isolierenden Schicht und der unteren Elektrode im wesentlichen gleich sind. Das charakteristische Abtragsverhalten des chemisch-mechanischen Polierens bewerkstelligt hierbei, dass nur jene Bereiche des isolierenden Materials entfernt werden, die oberhalb der Elektrode sind.

Gemäß einem anderen Ausführungsbeispiel wird zunächst die isolierende Schicht wie zuvor erläutert erzeugt. Anschließend wird jedoch mit Hilfe einer Lackmaske jener Teil des isolierenden Materials weggeätzt, das auf der Elektrode liegt. Aufgrund von Justagetoleranzen bei der Lithographie ist es notwendig, dass die Ätzöffnung im Lack kleiner als die Elektrode ist, da sonst die Topologiestufe bei der Ätzung wieder freigelegt werden könnte. Die Ätzung kann dabei sowohl nasschemisch als auch durch Trockenätzung (Plasmaätzung) erfolgen. Als Resultat bleibt ein "Kragen" aus dem isolierenden Material auf der Elektrode zurück. Dieser wird anschließend durch ein chemisch-mechanisches Polieren entfernt, so dass eine im wesentlichen planare Oberfläche zurückbleibt.

Gemäß einem anderen Ausführungsbeispiel wird zunächst die isolierende Schicht erzeugt, und anschließend eine Öffnung in derselben gebildet, in der dann das Metall für die Elektrode abgeschieden wird, derart, dass die sich ergebenden Oberflächen von isolierender Schicht und Elektrode im wesentlichen bündig sind.

Bevorzugte Weiterbildungen der vorliegenden Anmeldung sind in den Unteransprüchen definiert.

Nachfolgend werden anhand der beiliegenden Zeichnungen bevorzugte Ausführungsbeispiele der vorliegenden Erfindung näher erläutert. Es zeigen:,
Fig. 1A und 1B ein bekanntes Herstellungsverfahren zur Erzeugung eines BAW-Resonators, bei dem sich aufgrund einer Topologiestufe ein Wachstumsdefekt einstellt;
Fig. 2A bis 2C ein erstes Ausführungsbeispiel des erfindungsgemäßen Herstellungsverfahrens;
Fig. 3A bis 3C ein zweites Ausführungsbeispiel des erfindungsgemäßen Herstellungsverfahrens; und
Fig. 4 ein drittes Ausführungsbeispiel des erfindungsgemäßen Herstellungsverfahrens bei einer gestapelten Reonatoranordnung.

In der nachfolgenden Beschreibung der bevorzugten Ausführungsbeispiele der vorliegenden Erfindung werden für Elemente, die bereits anhand der Fig. 1 erläutert und beschrieben wurde, gleiche Bezugszeichen verwendet.

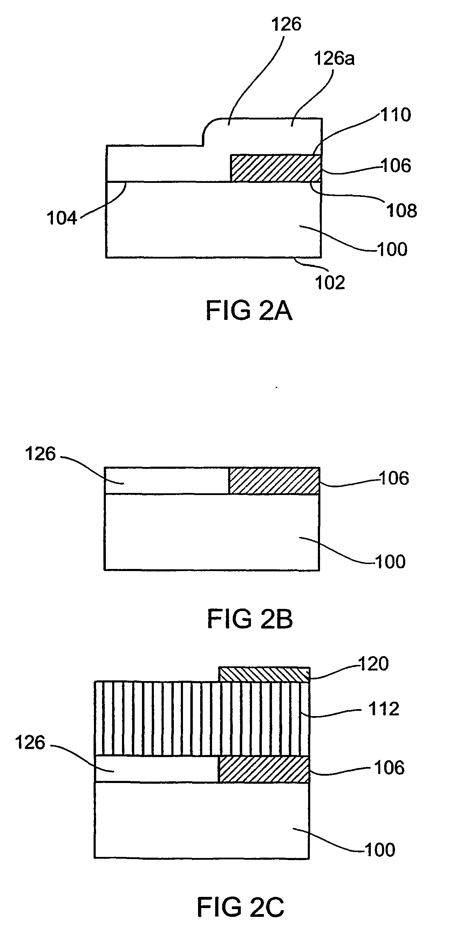

In Fig. 2A ist das Substrat 100 gezeigt, wobei auf einem Abschnitt der oberen Oberfläche 104 des Substrats 100 eine Elektrode 106, beispielsweise aus Aluminium, gebildet ist. Alternativ kann die Elektrode 106 auch aus Wolfram, einer Kombination von Aluminium und Wolfram oder anderen geeigneten Metallen gebildet sein.

Zur Vermeidung der Topologiestufe wird gemäß dem in Fig. 2 beschriebenen Ausführungsbeispiel auf den freiliegenden Abschnitt der Substratoberfläche 104 sowie auf die obere Oberfläche 110 der Elektrode 106 eine isolierende Schicht 126 abgeschieden. Bei dem dargestellten Ausführungsbeispiel ist die isolierende Schicht 126 eine Siliziumoxidschicht oder eine Siliziumnitridschicht.

Die in Fig. 2A dargestellte Struktur wird anschließend einem chemisch-mechanischen Dünnungsprozess unterworfen, mit dem ein Abschnitt 126a, der im Bereich der Elektrode 106 angeordnet ist, derart gedünnt wird, dass die obere Oberfläche 110 der Elektrode 106 frei liegt. Ferner werden die verbleibenden Abschnitte der isolierenden Schicht 126 derart gedünnt, dass die Dicke der Elektrode 106 und die Dicke der isolierenden Schicht 126 im wesentlichen gleich ist, so dass sich eine im wesentlichen planare Oberfläche ergibt, wie die in Fig. 2B gezeigt ist.

In Fig. 2C ist die sich nach dem Polierschritt ergebende Struktur dargestellt, und wie zu erkennen ist, sind die dem Substrat abgewandten Oberflächen der isolierenden Schicht 126 und der Elektrode 106 im wesentlichen planar, und auf dieser Oberfläche ist die piezoelektrische Schicht 112 abgeschieden, auf der wiederum die obere Elektrode 120 abgeschieden ist.

Der Vorteil des erfindungsgemäßen Verfahrens liegt auf der Hand, da hier die im Stand der Technik beschriebenen und bekannten Probleme aufgrund von Wachstumsdefekten einfach dadurch vermieden werden, dass eine Topologiestufe bei der Herstellung des Resonators eliminiert wird. Dies hat den Vorteil, dass die erwähnten elektrischen Kurzschlüsse, welche die Funktion des Bauelements (z.B. ein Filter, das entsprechende Resonatoren umfasst) degradieren oder gar zerstören können, nicht auftreten, dass eine erwünschte ESD-Festigkeit erreicht wird, aufgrund der im wesentlichen vollständig planaren Anordnung, und dass die Unterdrückung von unerwünschten Störmoden verbessert wird, da hier im Bereich außerhalb der oberen Elektrode 120 über einen großen Bereich eine definierte Geometrie (Dicke) vorliegt.

Das oben beschriebene Entfernen der dielektrischen Schicht 126A oberhalb der Elektrode 106 erfolgt bei dem in Fig. 2 dargestellten Ausführungsbeispiel direkt mit einem sehr harten Polier-Pad. In diesem Fall ist es erforderlich, eine hohe Polier-Selektivität zwischen der dielektrischen Schicht 126 und dem Material der Elektrode 106 zu haben, um sicherzustellen, dass bei Erreichen der oberen Oberfläche 110 der Elektrode 106 im wesentlichen kein Elektrodenmaterial abgetragen wird.

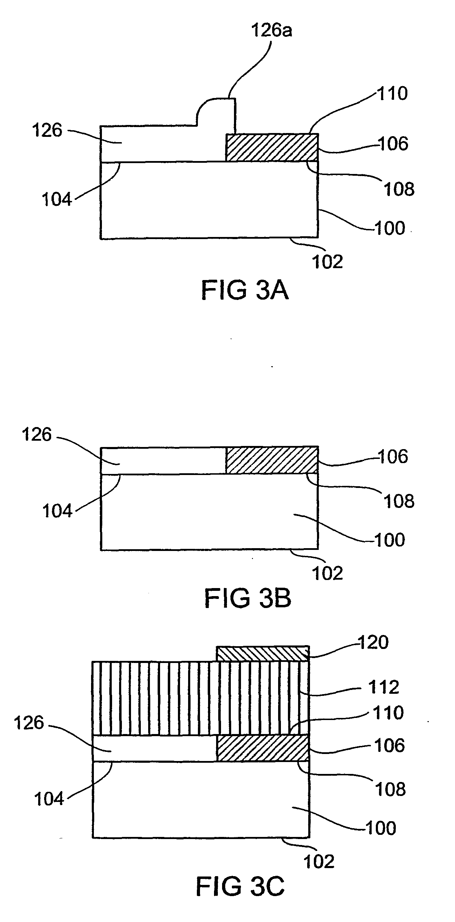

Um mögliche Probleme bei der erforderlichen hohen Polier-Selektivität zwischen der dielektrischen Schicht 126 und dem Material der Elektrode 106 zu vermeiden, wird gemäß einem zweiten Ausführungsbeispiel der vorliegenden Erfindung ein anderer Ansatz herangezogen, welcher deutlich geringere Anforderungen hinsichtlich der Pad-Härte und/oder der Selektivität des Polierverfahrens hat. Dieses weitere Ausführungsbeispiel wird nachfolgend anhand der Fig. 3 näher erläutert, wobei auch hier gleiche oder ähnliche Elemente mit gleichen Bezugszeichen versehen sind.

Bei dem in Fig. 3 dargestellten Ausführungsbeispiel wird ausgegangen von einer Struktur, wie sie in Fig. 2A dargestellt ist, nämlich einer Struktur bei der auf dem Substrat 100 bereits die Elektrode 106 und darauf die isolierende Schicht 126 abgeschieden ist.

Anders als bei dem in Fig. 2 beschriebenen Ausführungsbeispiel wird hier keine chemisch-mechanische Polierung der gesamten Oberfläche durchgeführt, sondern statt dessen wird unter Verwendung einer photolithographischen Maske (nicht dargestellt) die dielektrische Schicht 126 im Bereich innerhalb der Elektrode 106 entfernt, beispielsweise durch Ätzen der dielektrischen Schicht 126, um die obere Oberfläche 110 der Elektrode 106 zumindest teilweise freizulegen, wie dies in Fig. 3A gezeigt ist. Wie zu sehen ist, ist hier noch ein schmaler Steg 126a des Abschnitts der isolierenden Schicht 126 oberhalb der Elektrode 106 verblieben. Der Vorteil dieser Vorgehensweise besteht darin, dass nun lediglich der schmale Steg 126A zurückbleibt, welcher, im Gegensatz zur Entfernung oder Polierung der gesamten Schicht 126 in sehr kurzer Zeit und bei deutlich entspannten Polierbedingungen entfernt werden kann, so dass sich die in Fig. 3B gezeigte Struktur ergibt.

In Fig. 3C ist die sich ergebende Struktur nach dem Polieren und dem Aufwachsen der piezoelektrischen Schicht 112 sowie der oberen Elektrode 120 dargestellt, und die in Fig. 3C gezeigte Struktur entspricht der in Fig. 2C gezeigten Struktur. Der Vorteil der in Fig. 3 beschriebenen Vorgehensweise besteht darin, dass bei diesem Ausführungsbeispiel, welches die zusätzliche Maske und das Ätzen der dielektrischen Schicht 126 verwendet, die unerwünschte Topologiestufe auf technisch besonders einfache Weise verhindert werden kann.

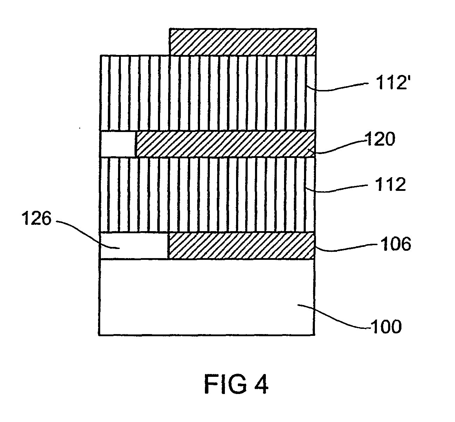

Das oben beschrieben Verfahren zur Erzeugung einer Elektrode ohne Topologiestufe kann auch für sogenannte gestapelte BAW-Resonatoren/Filter mit einer Mehrzahl von piezoelektrischen Schichten (Stacked Resonator/Filter) verwendet werden. In Fig. 4 ist ein solcher Resonator dargestellt. Wie zu erkennen ist, wurde das erfindungsgemäße Verfahren zur Erzeugung der Elektrode sowohl auf die Bodenelektrode 106 als auch auf die Mittelelektrode 120 angewandt. Dadurch können beide piezoelektrischen Schichten 112, 112' ohne Versetzunglinien abgeschieden werden. Ausführungsformen mit mehr als zwei Piezoschichten sind analog herstellbar.

### Bezugszeichenliste

- 100: Substrat
- 102: untere Oberfläche des Substrats
- 104: obere Oberfläche des Substrats
- 106: untere Elektrode
- 108: untere Oberfläche der unteren Elektrode
- 110: obere Oberfläche der unteren Elektrode
- 112: piezoelektrische Schicht
- 114: Technologiestufe
- 116: Wachstumsdefekt
- 118: Wachstumslinien
- 120: obere Elektrode
- 122: obere Oberfläche der piezoelektrischen Schicht
- 124: metallischer Spacer
- 126: isolierende Schicht
- 126A: Abschnitt der isolierenden Schicht

## Patentansprüche

1. Verfahren zur Herstellung eines Resonators in Dünnfilmtechnologie, wobei der Resonator eine piezoelektrische Schicht (112) umfasst, die teilweise zwischen einer unteren Elektrode (106) und einer oberen Elektrode (120) angeordnet ist, wobei der Resonator auf einem Substrat (100) gebildet wird, **dadurch gekennteichnet dass** das Verfahren die folgenden Schritten umfasst :
(a) Erzeugen der unteren Elektrode (106) des Resonators auf einem Abschnitt des Substrats (100);
(b) Abscheiden einer isolierenden Schicht (126) auf einem freiliegenden Abschnitt der Oberfläche des Substrats (100) und auf der unteren Elektrode (106) mit einer Dicke, die gleich der Dicke der Elektrode ist;
(c) Abtragen der isolierenden Schicht (126) derart, dass eine Oberfläche (110) der unteren Elektrode (106) freiliegt, und dass eine durch die untere Elektrode (106) und die isolierende Schicht (126) festgelegte Oberfläche im wesentlichen planar ist;
(d) Erzeugen der piezoelektrischen Schicht (114) auf der sich nach dem Schritt (c) ergebenden Struktur; und
(e) Erzeugen der oberen Elektrode (120) auf der piezoelektrischen Schicht (114).

2. Verfahren nach Anspruch 1, bei dem der Schritt des Abtragens das Entfernen der isolierenden Schicht (126A) oberhalb der Elektrode durch ein chemisch-mechanisches Polieren umfasst.

3. Verfahren nach Anspruch 1, bei dem der Schritt des Abtragens folgende Teilschritte umfasst:
(c.1) Ätzen eines Teils (126A) der isolierenden Schicht (126) oberhalb der unteren Elektrode unter Verwendung einer Maske, derart, dass ein Abschnitt der oberen Oberfläche der unteren Elektrode freigelegt wird; und
(c.2) Entfernen des nach dem Schritt (c.1.) verbleibenden Kragens durch ein chemisch-mechanisches Polieren.

4. Verfahren nach einem der Ansprüche 1 bis 3, bei dem die isolierende Schicht (126) eine dielektrische Schicht ist.

5. Verfahren nach Anspruch 4, bei dem die dielektrische Schicht (126) eine Siliziumnitridschicht oder eine Siliziumoxidschicht ist.

6. Verfahren nach einem der Ansprüche 1 bis 5, bei dem die piezoelektrische Schicht (114) aus A1N, ZnO oder PZT hergestellt ist.

7. Verfahren nach einem der Ansprüche 1 bis 6, bei dem die untere Elektrode (106) und die obere Elektrode (110) Aluminium und/oder Wolfram umfassen.

8. Verfahren nach einem der Ansprüche 1 bis 7, bei dem der Resonator ein BAW-Resonator ist.

## Claims

1. Method for manufacturing a resonator in thin-film technology, wherein the resonator includes a piezoelectric layer (11) partially arranged between a bottom electrode (106) and a top electrode (120), wherein the resonator is formed on a substrate (100),
**characterized in that** the method includes the following steps:
(a) generating the bottom electrode (106) of the resonator on a portion of the substrate (100);
(b) depositing an insulating layer (126) on an exposed portion of the surface of the substrate (100) and on the bottom electrode (106) with a thickness which is equal to the thickness of the electrode;
(c) lifting off the insulating layer (126) such that a surface (110) of the bottom electrode (106) is exposed and that a surface determined by the bottom electrode (106) and the insulating layer (126) is basically planar;
(d) generating a piezoelectric layer (114) on the structure resulting after step (c); and
(e) generating the top electrode (120) on the piezoelectric layer (114).

2. Method according to claim 1, wherein the step of lifting off includes removing the insulating layer (126A) above the electrode by a chemical-mechanical polishing.

3. Method according to claim 1, wherein the step of lifting off further includes the following sub-steps:
(c.1) etching a part (126A) of the insulating layer (126) above the bottom electrode using a mask, such that a portion of the top surface of the bottom electrode is exposed; and
(c.2) removing the collar remaining after the step (c.1) by a chemical-mechanical polishing.

4. Method according to one of claims 1 to 3, wherein the insulating layer (126) is a dielectric layer.

5. Method according to claim 4, wherein the dielectric layer (126) is a silicon nitride layer or a silicon oxide layer.

6. Method according to one of claims 1 to 5, wherein the piezoelectric layer (114) is manufactured from AlN, ZnO or PZT.

7. Method according to one of claims 1 to 6, wherein the bottom electrode (106) and the top electrode (110) include aluminium and/or tungsten.

8. Method according to one of claims 1 to 7, wherein the resonator is a BAW resonator.

## Revendications

1. Procédé de production d'un résonateur en technologie en couche mince, le résonateur comprenant une couche (112) piézoélectrique qui est disposée en partie entre une électrode (106) inférieure et une électrode (120) supérieure, le résonateur étant formé sur un substrat (100), **caractérisé en ce que** le procédé comprend les stades suivants :
(a) on produit l'électrode (106) inférieure du résonateur sur une partie du substrat (100) ;
(b) on dépose une couche (126) isolante sur une partie mise à nu de la surface du substrat (100) et sur l'électrode (106) inférieure en une épaisseur qui est égale à l'épaisseur de l'électrode ;
(c) on enlève la couche (126) isolante de façon à mettre à nu une surface (110) de l'électrode (106) inférieure et de façon à ce qu'une surface fixée par l'électrode (106) inférieure et la couche (126) isolante soient sensiblement

2. Procédé suivant la revendication 1, dans lequel le stade d'enlèvement comprend l'élimination de la couche (126A) isolante au-dessous de l'électrode par un polissage chémiomécanique.

3. Procédé suivant la revendication 1, dans lequel le stade d'enlèvement comprend les sous-stades suivants :
(c.1) on attaque une partie (126A) de la couche (126) isolante au-dessus de l'électrode inférieure en utilisant un masque de façon à mettre à nu une partie de la couche supérieure de l'électrode inférieure ; et
(c.2) on élimine par un polissage chémiomécanique le collet restant après le stade (c.1).

4. Procédé suivant l'une des revendications 1 à 3, dans lequel la couche (126) isolante est une couche diélectrique.

5. Procédé suivant la revendication 4, dans lequel la couche (126) diélectrique est une couche en nitrure de silicium ou une couche d'oxyde de silicium.

6. Procédé suivant l'une des revendications 1 à 5, dans lequel la couche (114) piézoélectrique est en AlN, ZnO ou PZT.

7. Procédé suivant l'une des revendications 1 à 6, dans lequel l'électrode (106) inférieure et l'électrode (110) supérieure comprennent de l'aluminium et/ou du tungstène.

8. Procédé suivant l'une des revendications 1 à 7, dans lequel le résonateur est un résonateur BAW.
